Europäisches Patentamt

European Patent Office

Office européen des brevets

(19)

(11) Veröffentlichungsnummer: **0 181 467**
**B1**

(12) **EUROPÄISCHE PATENTSCHRIFT**

(45) Veröffentlichungstag der Patentschrift: **18.07.90**

(51) Int. Cl.⁵: **G 01 R 33/06**

(21) Anmeldenummer: **85111918.0**

(22) Anmeldetag: **20.09.85**

(54) Differentialsensor.

(30) Priorität: **29.09.84 DE 3435867**

(43) Veröffentlichungstag der Anmeldung:
**21.05.86 Patentblatt 86/21**

(45) Bekanntmachung des Hinweises auf die
Patenterteilung:
**18.07.90 Patentblatt 90/29**

(84) Benannte Vertragsstaaten:
**DE FR GB IT**

(56) Entgegenhaltungen:
**EP-A-0 130 496**
**US-A-3 835 377**
**US-A-4 296 377**

(73) Patentinhaber: **ROBERT BOSCH GMBH**
**Postfach 50**
**D-7000 Stuttgart 1 (DE)**

(72) Erfinder: **Zabler, Erich, Dr.-Ing.**
**Brunhildstrasse 11**
**D-7513 Stutensee-B 1 (DE)**

(74) Vertreter: **Kammer, Arno, Dipl.-Ing.**
**ROBERT BOSCH GmbH Zentralstelle Patente 2**
**Postfach 50**
**D-7000 Stuttgart 1 (DE)**

Courier Press, Leamington Spa, England.

## Beschreibung

Die Erfindung betrifft einen magnetostriktiven Differentialsensor mit den Merkmalen des Oberbegriffs des Anspruchs 1.

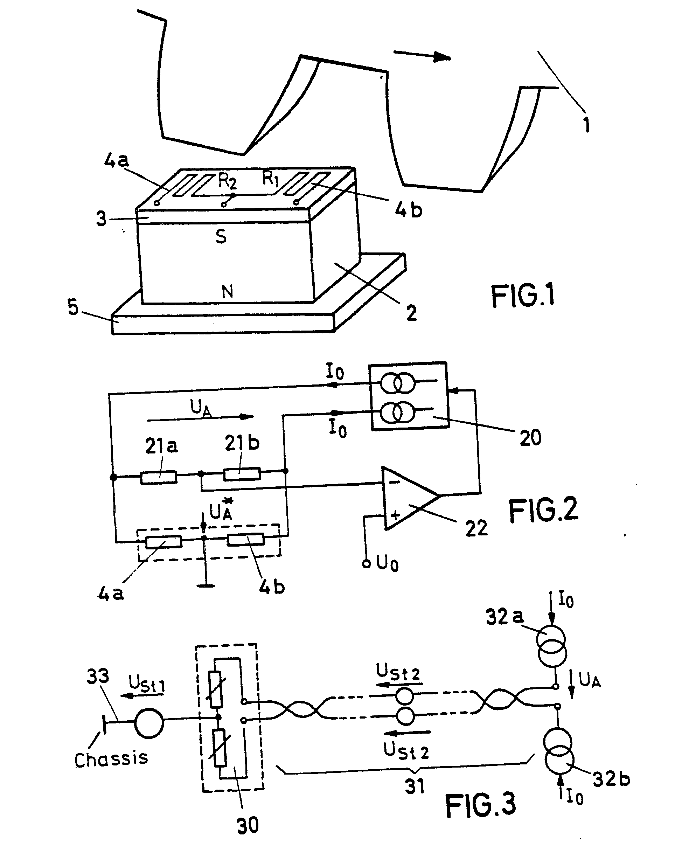

Magnetoresistive Differentialsensoren mit den Merkmalen des Oberbegriffs des Anspruches 1 sind aus der Fig. 1 und zugehöriger Beschreibung der US—A—3 835 377 bekannt.

Sensoren mit diesen Merkmalen sind z.B aus dem Siemens-Datenbuch Band 1 "Sensoren", Seite 60—69 bekannt. Dort liegen die beiden magnetfeldabhängigen Widerstände in Reihe an einer Gleichspannungsquelle und am Verbindungspunkt dieser Widerstände wird die Sensorspannung gegriffen.

Gegenüber den bekannten Sensoren hat der erfindungsgemäß ausgebildete Sensor mit den Merkmalen des Anspruchs 1 einmal den Vorteil, daß er bei sonst gleichen Verhältnissen die doppelte Sensorausgangsspannung abgibt, was z.B. bei vorgegebener Mindestspannung einen größeren Luftspalt erlaubt. Außerdem ist der erfindungsgemäße Sensor gegenüber in die Zuführungsleitung als Gleichtaktsignale eingekoppelten Störspannungen unempfindlich. Schließlich ist beim erfindungsgemäßen Sensor eine Erdung des Mittenanschlusses über das Gehäuse möglich, was zur Einsparung einer Leitung im Zuleitungskabel führt. Dies deshalb, weil ein durch Masseströme verfälschtes Erdpotential durch die Differenzauswertung eliminiert wird.

Anhand der Zeichnung wird ein Ausführungsbeispiel der Erfindung erläutert. Es zeigen:

Fig. 1 — den prinzipiellen Aufbau eines Differentialfeldplattensensors,

Fig. 2 — das zugehörige Schaltbild,

Fig. 3 — ein Schaltbild mit eingezeichneten Störquellen.

In Figur 1 ist ein Differentialsensor im Prinzip gezeigt. Er besteht aus einem zahnradähnlichen Rotor 1 und einem Stator, der einen Permanentmagneten 2, ein Substrat 3 (Ferrit) mit darauf aufgebrachten Feldplattenwiderständen 4a und 4b und ein weichmagnetisches Rückschlußteil 5 enthält. Beim Drehen des Rotors wird der Flüß des Magnetfelds des Permanentmagneten 2 geändert. Die Feldplattenwiderstände werden dadurch in ihrem Widerstandswert variiert.

Die Figur 2 zeigt die elektrische Verschaltung der beiden Widerstände 4a und 4b. Die benachbarten Anschlüsse der Widerstände 4a und 4b sind miteinander verbunden und an Erde gelegt. Die beiden anderen Anschlüsse der Widerstände 4a und 4b sind mit einer Dopplerstromquelle 20 verbunden, die den beiden Widerständen einen nur von der Temperatur abhängigen, sonst jedoch konstanten Strom $I_0$ zuführt. Zwischen den beiden Zuführungsleitungen kann auch die gewünschte Ausgangsspannung $U_A$, die in ihrer Frequenz der Drehzahl des Rotors proportional ist, abgegriffen werden. Parallel zu den Widerständen 4a und 4b liegt ein hochohmiger Spannungsteiler aus gleichen Widerständen 21a und 21b.

Zwischen den Verbindungen der beiden Widerstandspaare 4a/4b bzw. 21a/21b wird eine Spannung $U_A*$ abgegriffen, die in einem Komparator 22 mit einer konstanten Spannung $U_0$ verglichen wird. Die Abweichung der Spannung $U_A*$ von der Spannung $U_0$ ($U_0$ ist die maximal zulässige mittlere Speisespannung der Feldplatten, bei der im Betriebsbereich keine thermische Überlastung der Feldplatten eintritt) wird der Doppelstromquelle 20 zur Regelung des Stromes $I_0$ zugeführt. Diese Regelung ist notwendig, um den Einfluß von durch Temperaturschwankungen hervorgerufene Änderungen der Widerstände 4a und 4b zu kompensieren. Die Regelung erfolgt so, daß bei allen Temperaturen am Ruhewiderstand jeder Feldplatte die Spannung $U_0$ liegt. Bei fallendem Widerstandswert wird dazu der Strom entsprechend angehoben. Die Ausgangsspannung ist bei dieser Lösung

$$U_A = U_0 \cdot \frac{\Delta_R}{R},$$

wenn R der Ruhewiderstand der Feldplatten und $\Delta_R$ deren Unterschied bei Rotordrehung ist.

In Figur 3 ist der Sensor 30 über Zuleitungen 31 mit den Stromquellen 32a und 32b verbunden. In die Zuleitungen 31 und die Erdleitungen sind Störspannungsquellen $U_{St\,1}$ und $U_{St\,2}$ eingezeichnet. Störspannungen dieser Quellen werden bei der vorliegenden Schaltung als Gleichtaktsignale eliminiert.

## Patentansprüche

1. Magnetoresistiver Differentialsensor, insbesondere aus Feldplatten, bei dem die beiden magnetfeldabhängigen Widerstände mit ihren benachbart liegenden Anschlüssen miteinander verbunden und stromdurchflossen sind, bei dem parallel zu den Sensorwiderständen ein hochohmiger Spannungsteiler aus gleichgroßen Wiederständen liegt und bei dem die freien Anschlüsse der beiden Widerstandspaare mit einer Stromquelle verbunden sind, dadurch gekennzeichnet, daß die Verbindung der beiden magnetfeldabhängigen Widerstände geerdet ist, daß die Spannung ($U_A$) zwischen den beiden freien Anschlüssen als Sensorausgangsspannung verwendet wird, daß die zwischen dem Mittenabgriff des Spannungsteilers und Erde abgegriffene Spannung ($U_A*$) mit einer vorgegebenen Spannung ($U_0$) verglichen wird und daß die Abweichung zu einer derartigen Spannungsregelung der Stromquelle benutzt wird, daß trotz Änderung des Ruhewiderstands der magnetfeldabhängigen Widerstände (4a, 4b) bei sich ändernder Temperatur an jedem dieser Ruhewiderstände immer eine konstante Spannung ($U_0$) ansteht.

2. Magnetoresistiver Differentialsensor nach Anspruch 1 oder 2, dadurch gekennzeichnet, daß jeder der beiden freien Anschlüsse mit je einer Stromquelle, insbesondere mit einem Anschluß einer Doppelstromquelle (20) verbunden ist.

# EP 0 181 467 B1

## Revendications

1. Capteur différentiel à effet magnétorésistif notamment formé de plaques de champ avec des résistances dépendant du champ magnétique et dont les bornes voisines sont reliées entre elles et sont traversées par un courant, avec en parallèle aux résistances du capteur, un diviseur de tension fortement ohmique formé de résistances égales et les bornes libres des deux paires de résistances étant reliées à une source de courant, capteur caractérisé en ce que la liaison des deux résistances dépendant du champ magnétique est mise à la masse, la tension ($U_A$) entre les deux bornes libres est exploitée comme tension de sortie du capteur et la tension ($U_A^*$) prise entre la borne médiane du diviseur de tension et la masse est comparée à une tension prédéterminée ($U_0$), la différence servant à réguler la tension de la source de courant pour que quelles que soient les variations de la résistance de repos des résistances dépendant du champ (4a, 4b) pour une température variable donne toujours une tension constant ($U_0$) sur chaque résistance de repos.

2. Capteur différentiel à effet magnétorésistif selon la revendication 1 ou 2, caractérisé en ce que chacune des deux bornes libres est reliée respectivement à une source de courant notamment à une borne d'une source de courant double (20).

## Claims

1. Magnetoresistive differential sensor, in particular of magnetoresistors, in which the two magnetic field-dependent resistors are interconnected by their neighbouring terminals and have current flowing through them, in which a high-impedance voltage divider of resistors of the same size is in parallel with the sensor resistors and in which the free terminals of the two resistor pairs are connected to a current source, characterized in that the connection of the two magnetic field-dependent resistors is earthed, in that the voltage ($U_A$) between the two free terminals is used as sensor output voltage, in that the voltage ($U_A^*$) picked off between the centre tap of the voltage divider and earth is compared with a given voltage ($U_0$) and in that the deviation is used for such a voltage control of the current source that, in spite of a change in the rest resistance of the magnetic field-dependent resistors (4a, 4b) with changing temperature, there is always a constant voltage ($U_0$) at each of these rest resistances.

2. Magnetoresistive differential sensor according to Claim 1 or 2, characterized in that each of the two free terminals is connected to a current source each, in particular to a terminal of a double current source (20).

FIG.1

FIG.2

FIG.3